# EUROPEAN PATENT APPLICATION

(11) **EP 4 481 829 A1**
(43) Date of publication of application: **25.12.2024**
(21) Application number: 23180699.3
(22) Date of filing: 21.06.2023
(51) Int. Cl.: H01L 29/78, H01L 21/336, H01L 29/66

(54) **SEMICONDUCTOR DIE WITH A VERTICAL TRANSISTOR DEVICE**

(71) Applicant: Infineon Technologies Austria AG, 9500 Villach (AT)
(72) Inventor: FERRARA, Alessandro, 9523 Villach (AT); TAMBONE, Riccardo, 9500 Villach (AT)
(74) Representative: König Szynka Tilmann von Renesse Patentanwälte Partnerschaft mbB München

(57) **Abstract**

A semiconductor die (1) with a semiconductor body (15), the semiconductor die (1) comprising a transistor device (10) comprising a source region (11) at a first side (15.1) of the semiconductor body (15), a drain region (12) at a second side (15.2) of the semiconductor body (15), a trench (25) extending from the first side (15.1) into the semiconductor body (15) and having an elongated lateral extension, a first trench electrode (30) for a channel creation or field shaping, having an elongated lateral extension (35) and disposed in the trench (25), and a control electrode contact (31) contacting the first trench electrode (30) from the first side (15.1) of the semiconductor body (15) for applying an electrical potential, the control electrode contact (31) disposed at a first lateral position (41); and a sense electrode contact (32) contacting the first trench electrode (30) from the first side (15.1) of the semiconductor body (15) for sensing a voltage from the first trench electrode (30), wherein the sense electrode contact (32) is disposed at a second lateral position (42) which is spaced from the first lateral position (41).

## Description

### TECHNICAL FIELD

The present disclosure relates to a semiconductor die with a semiconductor body, comprising a vertical transistor device.

### BACKGROUND

A vertical transistor device may have a source region at a first side and a drain region at a second side of the semiconductor body. A trench extends from the first side into the semiconductor body. In the trench, a first trench electrode is disposed, which can for instance be a gate electrode for a channel creation or a field electrode for a field shaping. The first trench electrode is contacted via a control electrode contact to apply a respective electrical potential to the first trench electrode, for example a gate potential or source potential. For example, a gate electrode and a field electrode arranged below the gate electrode, both can be disposed in the same trench.

### SUMMARY

It is an object of the present application to provide an advantageous semiconductor die with a vertical transistor device.

In the semiconductor die of claim 1, a sense electrode contact contacting the first trench electrode from the first side of the semiconductor body is provided in addition to the control electrode contact. It is disposed at a second lateral position which is spaced apart from a first lateral position at which the control electrode contact is disposed. Via the sense electrode contact, the first trench electrode can for instance be used for capacitively sensing a variation in the drain potential. In other words, the first trench electrode can be used as a first capacitor electrode which forms a capacitor together with a second capacitor electrode disposed at the second side of the semiconductor body, in particular with the drain region in case of a common drain backside. Therein, an "active" electrode which is already part of the vertical device is used for sensing the backside potential or transients, which can for instance allow for an area reduction, e. g. compared to a separate sense electrode aside the transistor device.

The variation of the backside potential can in particular be a variation of the drain to source voltage and fast transients can be associated to potential failure mechanisms, such as a dynamic avalanche and dynamic return-on. Such events can for example occur when the drain to source voltage varies too quickly, triggering for instance a parasitic dynamic current (which can lead to failure or degradation). The present setup can allow for sensing such fast transients and enable countermeasures, thus, either internally or externally, see in detail below. The internal resistance of the first trench electrode, e. g. its resistance between the control and the sense contacts, can contribute to or determine a difference between the control potential applied and the potential sensed, as well as a time delay between the backside potential and the sensed voltage.

Particular embodiments and features are presented throughout this disclosure and in the dependent claims. Thereby, the individual features shall be disclosed independently of a specific claim category, the disclosure relates to apparatus and device aspects, but also to method and use aspects. If for instance a die manufactured or used in a specific way is described, this is also a disclosure of a respective manufacturing process or use, and vice versa. In general words, an approach of this application is to provide a vertical device which has an active electrode in a trench and to use the active electrode of the device as a sense electrode (first trench electrode). Via the control electrode contact, the first trench electrode can be tied to the electrical potential required for the use in the device, whereas the sense electrode contact disposed at a distance therefrom can allow for a probing of changes caused by the capacitive coupling of the first trench electrode.

The trench in which the first trench electrode is disposed can be arranged in the active area of the vertical device. It can for instance extend into a body region and/or into a drift region of the vertical device. The sense electrode, namely first trench electrode, disposed in the trench can for instance be used in the device for a field shaping, for example be disposed laterally aside the drift region of the vertical device for a field shaping in the drift region. Alternatively, it can be disposed in the trench and laterally aside the body region of the vertical device, namely capacitively couple to this body region such that a channel of the vertical device is formed there by the first trench electrode. In other words, the sense electrode can in particular be the gate or field electrode of the vertical device. The vertical device is configured for a vertical current flow in operation between its source region and drain region and the sense electrode can for instance control this current flow by the channel creation or shape an electrical field, e. g. during the current flow and/or in a blocking state of the vertical device.

The source region and the drain region of the vertical device are disposed at vertically opposite sides of the semiconductor body, wherein the "first side" can also be referred to as a frontside and the "second side" as a backside. In a body region of the device, a channel can be formed by applying a voltage to the gate electrode of the vertical device. Even though the transistor device as a whole is considered "vertical" due to its vertically opposite source and drain region, a lateral channel is conceivable in general, e. g. in case of a gate region disposed on top of the body region (and a source region laterally aside the latter). The gate electrode of the vertical device is not necessarily disposed in a trench, still a field electrode can be arranged in a trench and can be the "active" electrode of the device used for sensing. In particular, however, the gate region is disposed laterally aside the body region and the channel extends vertically aside a trench, see in detail below.

The semiconductor body can comprise a substrate and one or more epitaxial layers which can in particular form the first side of the semiconductor body. The trench extends from the first side into the semiconductor body, for example into an epitaxial layer; its lower end can in particular lie above the substrate, for instance in a drift region formed in an epitaxial layer. Laterally, the trench and the first trench electrode have an elongated extension, the lateral length being a multiple of the vertical depth. Seen in a vertical top view, the trench and the first trench electrode can in particular extend as a straight line ("stripe shape"), the transistor device comprising for instance a plurality of device cells, each having a stripe shape and the stripes disposed as parallel lines. Alternatively, a matrix-like cell arrangement is possible as well, the cells having for instance a polygonal shape, for instance quadratic cells. In this case, the trench can form a grid, wherein the gate electrode disposed therein can nonetheless be used for sensing, see in detail below.

"Vertical" or "vertically" refer to the vertical direction which lies for instance perpendicular to a surface of the die, e. g. the surface of a substrate or an epitaxial layer formed on the substrate. "Above" means vertically aligned and closer to the first side of the die and "below" means vertically aligned and closer to the second side. "Lateral" or "laterally" refer to the lateral directions perpendicular to the vertical direction, in which for instance the die area is taken. On the first side of the semiconductor body, an insulating layer can be disposed, for instance made of silicon oxide or borophosphosilicate glass (BPSG). Above, one or more metallization layers can be formed. The sense and/or control electrode contact can in particular extend through the insulating layer, for instance for a further connection and wiring in the metallization layer.

In an embodiment, the control electrode contact is disposed in a first half of the lateral extension of the first trench electrode and the sense electrode contact is disposed in a second half thereof. Alternatively or in addition, a minimum lateral distance between the control electrode contact and the sense electrode contact can for instance be at least 10%, 30%, 50%, 70% or 90% of the lateral extension of the first trench electrode. In absolute values, the lateral distance can for instance be 0.1mm, 0.2 mm, 0.5 mm, 1 mm, 1.5 mm, 2 mm or 5mm, which can also depend on the die size. Generally, when a "distance" between two elements is considered, it is taken as the smallest distance in between these elements in the respective direction (not as a center-to-center-distance), wherein the lateral extension of the first trench electrode and respective distance is taken in a first lateral direction. Independently of the implementation or way of measuring in detail, a certain lateral distance between the contacts can for instance allow for a required time delay and/or potential difference between the contacts.

In particular, the control electrode contact can be disposed at a first lateral end of the first trench electrode and/or the sense electrode contact can be disposed at a second lateral end thereof, the first and second end lying laterally opposite to each other. "Disposed at a lateral end" means for instance arranged at a maximum distance from the respective end of not more than 10% of the lateral extension of the first trench electrode, in particular not more than 5%. Seen in a vertical top view, the first trench electrode can for example have a stripe shape (see above), wherein the electrode contacts are disposed at opposite ends of the stripe.

In an embodiment, no other electrode contact contacting the first trench electrode is disposed laterally between the control electrode contact and the sense electrode contact. In other words, the first trench electrode can be covered over the whole distance between the contacts by an uninterrupted insulating layer, for instance an oxide layer, e. g. silicon oxide In case of a field electrode used for sensing (see below), this insulating layer can for instance separate it from the gate electrode above.

As discussed above, the gate region of the vertical device, which comprises the gate electrode and a gate dielectric, can in particular be arranged laterally aside the body region, the gate electrode disposed in a trench. In a particular embodiment, this gate electrode is used as the first trench electrode, the gate potential applied via the control electrode contact and transients being sensed via the sense electrode contact. Independently of whether the gate electrode forms a stripe or grid pattern, it has an elongated extension in at least one lateral direction (first lateral direction) in which the control and sense electrode contact are disposed with a lateral distance in between.

Regardless of whether the channel has a lateral or vertical extension and of the particular cell layout (stripe or grid), the vertical transistor device can in particular comprise a drift region made of the same doping type but with a lower doping concentration compared to the drain region. Referring to a source and drain region made of a first doping type, and a body region made of a second doping type, the drift region can be made of the first doping type as well. Vertically, it can be disposed between the body region and the drain region, for instance in an epitaxial layer on the substrate. In the exemplary embodiments, the first type is n-type and the second type is p-type. In particular, the device can comprise a field electrode in a trench which extends into the drift region. Via a field dielectric, the field electrode capacitively couples to the drift region, which allows for a field shaping by applying a potential to the field electrode, for instance a gate or in particular source potential. In general, the field electrode can have a spicular shape, for instance in case of a grid-like gate pattern (with a spicular field electrode in each cell), wherein for instance a portion of the grid-like gate pattern can be used for sensing.

In a particular embodiment, however, an elongated field electrode is disposed in a trench having an elongated lateral extension, in particular a stripe-shape seen in top view. In particular, the elongated field electrode is used for sensing and acts as first trench electrode. Thus, in addition to the control electrode contact for applying the potential for field shaping, the field electrode is contacted via the sense electrode contact. Since the field electrode extends in the drift region, it can be comparably close to the backside or drain region, which can for example be advantageous in capacitively sensing transients.

In addition to the elongated field electrode in the trench, the vertical device can comprise an elongated gate electrode in a trench, generally in a separate trench aside the field electrode trench or in particular above the field electrode in the same trench. These electrodes can be electrically isolated from each other by an insulating layer disposed vertically between in the trench. In case of a device with an elongated field electrode and an elongated gate electrode, one or both of these electrodes can be used for sensing. In the latter case, the field electrode can be the "first trench electrode" and the gate electrode can act as a "second trench electrode" which is contacted by a sense electrode contact in addition to the control electrode contact for applying the gate potential. Generally, any design or feature described for the first trench electrode shall also be disclosed for the second trench electrode.

In general, the sensing function can be used or processed externally, for instance in an external control circuit for the vertical device or even independently of the actual device operation, for example for evaluation purposes. In particular, however, a controllable clamping device is integrated in the same die with the vertical device and connected thereto. The clamping device can have a control terminal and load terminals, wherein the voltage applied to the control terminal can for instance control a current flow between the load terminals. By connecting the sense electrode contact to the control terminal of the clamping device, a change in the electrical potential, e. g. due to backside transients, sensed via the trench electrode of the vertical device can be used to switch or trigger the controllable clamping device.

The clamping device can for instance be connected with its load contacts between the drain and gate contact of the vertical device or between the gate and source contact of the vertical device, namely as a pull-down device. In case that the gate to source voltage of the vertical device would increase above the threshold voltage of the vertical device, an induced turn-on could result while the device should actually be in the off-state. This can be prevented by the pull-down device which can be in the on-state (conducting) when the vertical device is off or can be triggered during a fast switching transient that would turn on the vertical device (and cause for example losses and potentially device failure).

In a particular embodiment, the controllable clamping device is connected in parallel to the vertical device. One load contact of the clamping device is connected to the source region/contact of the vertical device and the other load contact is connected to the drain region/contact of the vertical device. In other words, the controllable clamping device is used as a shunt device. Generally, an advantage of the trench electrode adapted for sensing fast transients can be that it is for instance not activated in static or slow switching events. This can in particular be advantageous in view of the shunt device, because it does not reduce the static breakdown voltage, thus. Vice versa, it can protect the vertical device from fast switching events even if the drain to source voltage is much lower than the static breakdown voltage.

In an embodiment, the controllable clamping device is a transistor device, a MOS-gated diode or a field electrode-controlled diode. By applying a voltage to the field electrode of the field electrode-controlled diode, its breakdown voltage can be adjusted. Thus, its field electrode is the control terminal connected to the sense electrode contact of the trench electrode of the vertical device. When the sensing voltage increases above a selected voltage, for instance adjusted to be slightly above 0 V, the diode goes in avalanche. To optimize the diode for an activation only during fast transients and not under static/slow switching, it can in particular have a different breakdown voltage versus field plate voltage dependence compared to the vertical device. The field electrode-controlled diode can for example be implemented as a design variation, for instance as an FET without a gate electrode. However, process variations are conceivable as well, such as a localized n-implant for the clamping device and/or a clamping device trench with a different geometry and/or oxide.

In case of a clamping FET, its gate electrode is the control terminal connected to the sense electrode contact of the trench electrode of the vertical device. When the sensed voltage exceeds the threshold voltage, the clamping FET starts conducting, connecting for instance as a shunt device source and drain of the vertical device. The shunt FET can have the same or a different threshold voltage than the vertical transistor, its threshold voltage can for instance be tuned by design or process adaptions (extra body implant for the shunt FET, different contact width/depth, extra source implant, different gate oxide thickness, or any other adaption to achieve a variation of the threshold voltage).

Independently of the particular type of controllable clamping device, the connection between its control terminal and the sense electrode contact can in particular be formed by a metal pad on the first side of the semiconductor body, the metal deposited for instance onto an insulating layer on the first side. The metal pad can for example be formed in the same metallization layer like a source metal and/or a gate metal of the vertical device, the latter having for instance one or in particular two metallization layers. In other words, the wiring of the clamping device and the vertical device does for instance not require an additional metallization layer. Laterally, the respective metal pad can be disposed rather centrally, for instance in case of a central sense bus line, or in particular in an edge portion of the die, for instance together with a gate metal pad or also without an edge gate pad.

The control terminal of the clamping device can be connected to the source region of the vertical device via a resistance Rₛₑₙₛₑ. In an embodiment, the resistance Rₛₑₙₛₑ is defined by the internal resistance of the first trench electrode, namely the resistance taken between the control electrode contact and the sense electrode contact. Alternatively or in addition, the control terminal of the clamping device is capacitively coupled to the drain region of the vertical device with a capacitance Cₛₑₙₛₑ, wherein the capacitance Cₛₑₙₛₑ can in particular be defined by the distributed capacitance between the first trench electrode and the drain, extending laterally across the elongated trench between the control electrode contact and the sense electrode contact, particularly in case of the field electrode used for sensing.

In an embodiment, the die comprises an additional transistor device connected in parallel to the (first) vertical transistor device. The additional transistor device can particularly be a vertical device as well, and the gate electrodes of these devices can be connected to each other, for instance by a gate runner. In other words, the transistor devices can be device cells of a common vertical transistor device, the cells having for instance a stripe or grid pattern (see in detail above). The first vertical transistor device comprises the trench electrode with the sense electrode contact and is used for sensing, whereas the additional transistor device can be provided without a sense electrode contact. Considering the whole cell field of the devices connected in parallel, the first vertical device can for instance have a proportion between 10%-90%, and the additional device can for instance have a complementary proportion between 90%-10% (so the relation between the first and the additional device may for instance be 10-90, 30-70, 50-50, 70-30, 90-10).

Independently of these details, the gate electrodes of these transistor devices / device cells, namely of the first device and the additional device, can be disposed in separate trenches, for instance trenches with a straight extension arranged in parallel to each other, namely as stripe-shaped cells. The stripe-shaped device cells can for instance have their respective length extension in a first lateral direction and be arranged translationally symmetrical to each other in a second lateral direction perpendicular thereto. In a particular embodiment, the control terminal (gate electrode or field plate, see above) of the controllable clamping device is disposed in a separate trench as well, for instance in another straight trench arranged in parallel to the other trenches.

In an embodiment, the transistor device and an additional transistor device have a grid-shaped gate structure, the gate electrodes crossing each other, some of the gate electrodes extending in a first lateral direction and other gate electrodes extending in a second lateral direction. The transistor device and the additional transistor device, which can respectively comprise a plurality of transistor device cells arranged in a grid pattern, are, as per definition, disposed aside each other in the second lateral direction. Then, in particular, at least some of the gate electrodes extending in the second lateral direction can be interrupted between the additional transistor device and the transistor device. The trench can extend continuously, e. g. filled with an insulating material to form the interruption, or can be interrupted as such by a respectively adapted etch mask.

The application relates also to a package in which a semiconductor die disclosed here is housed. The package can be a metal, plastics, glass, or ceramic casing, it can for instance allow for a further mounting and connecting on a board. The package can typically comprise a plurality of pins, for instance for the source and drain connection of the vertical device, typically also for its gate connection. In a particular embodiment, the package comprises a sense pin, for example in addition to the aforementioned pins, wherein the sense pin is electrically connected to the sense electrode contact of the die. This electrical connection can be formed inside the package, for example by a bond wire or clip or the like. The sense pin can allow for an external evaluation of the sensed backside transients, e. g. as an alternative or in addition to the internal circuitry discussed above.

The application relates also to a method of using a die disclosed here, or a package with a respective die, wherein an electrical potential is applied to the first trench electrode via the control electrode contact. This can for instance be a gate or source potential, see above. Additionally, an electrical potential is sensed via the sense electrode contact, for instance to sense backside transients. The sensed potential can be used externally and/or be in particular applied to the control terminal of a controllable clamping device which can be provided separately or can in particular be integrated in the same die.

The application relates also to a method of manufacturing the semiconductor die or package, comprising a forming of the transistor device and a forming of the sense electrode contact. The latter can in particular be formed in the same process step with the control electrode contact.

### BRIEF DESCRIPTION OF THE DRAWINGS

Below the semiconductor die with the vertical transistor device and the use and manufacturing are explained in further detail by means of exemplary embodiments. Therein, the individual features can also be relevant in a different combination.
- Figure 1: shows a schematic cross-section through a gate and field electrode and illustrates the use as sense electrodes;
- figure 2: shows a cross-section through a transistor device, the cross-sectional plane perpendicular to figure 1;
- figure 3: shows a circuit diagram illustrating the wiring of a transistor device with a monolithically integrated shunt FET;
- figure 4: shows a layout for an implementation of the wiring of figure 3 with stripe-shaped cells;
- figure 5: shows another circuit diagram which illustrates the wiring of a gate electrode of the vertical device used for sensing in combination with a field electrode-controlled diode as shunt device;
- figure 6: shows a layout for an implementation of the wiring of figure 5 with stripeshaped cells;
- figure 7: is a schematic top view illustrating a possible implementation of a gate sense structure in case of a cell grid with polygonal transistor cells;
- figure 8a: shows a flow diagram illustrating some steps of using the die;
- figure 8b: illustrates some steps of manufacturing the die;
- figure 9: shows a comparison of the dependence of the breakdown voltage from the field plate voltage for the vertical device and a field electrode-controlled diode as discussed in figure 5.

### DETAILED DESCRIPTION

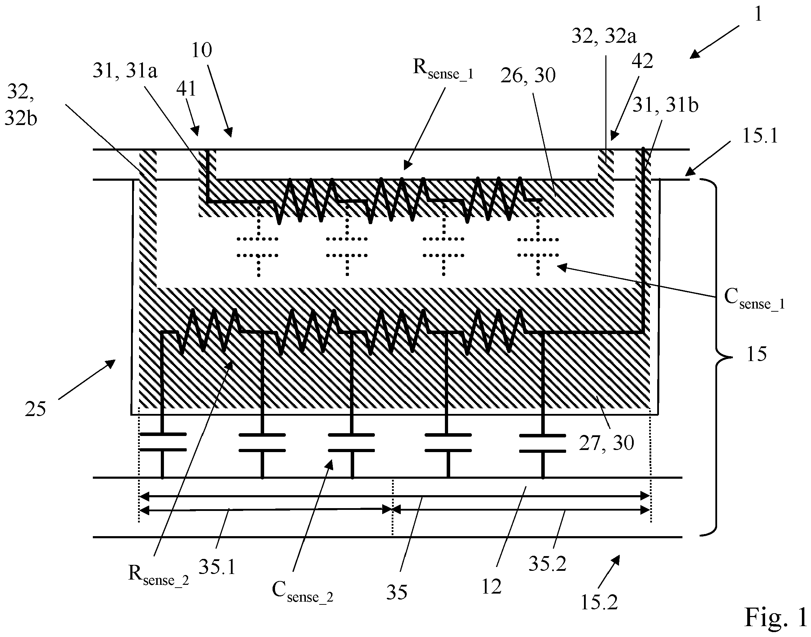

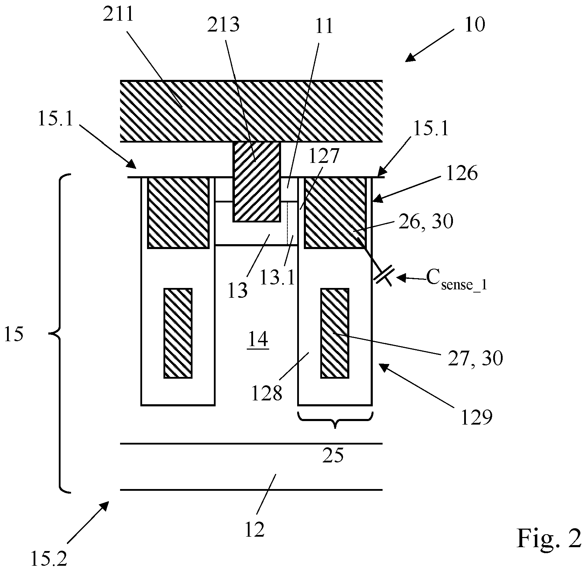

Figure 1 shows a cross-sectional view through a portion of a semiconductor die 1 with a semiconductor body 15 in which a transistor device 10 is formed. The latter has a vertical design, its source region (not visible in figure 1, see figure 2) is disposed at a first side 15.1 of the semiconductor body 15 and its drain region 12 at a vertically opposite second side 15.2 of the semiconductor body 15. The transistor device 10 comprises a trench 25 which extends from the first side 15.1 into the semiconductor body 15. In the trench 25, a gate electrode 26 and a field electrode 27 are disposed. As discussed above, in some embodiments, there is only one of the gate electrode 26 or the field electrode 27 disposed in the trench 25. Typically, the gate electrode 26 is used for a channel creation from the source region to the drain region 12 of the semiconductor body 15, and the field electrode 27 is used for field shaping (such as field shaping of the electric field within the source region, body region and/or drift region of the semiconductor body 15). Each of these electrodes 26, 27 is contacted via a respective control electrode contact 31, namely the gate electrode 26 via a gate control electrode contact 31a and the field electrode 27 via a field control electrode contact 31b. Via the respective control electrode contact 31, an electrical potential can be applied to the respective electrode 26, 27, namely a gate potential to the gate electrode 26 and for instance a source potential to the field electrode 27.

In addition to the control electrode contacts 31 disposed at a first lateral position 41, a respective sense electrode contact 32 disposed a second lateral position 42 is provided (the lateral positions of the contacts referenced only for the gate electrode 26). Thus, the respective electrode 26, 27 cannot only be used for a channel creation or field shaping but also for sensing. In case of a respective use of the gate electrode 26, it can be considered as a "first trench electrode" 30 contacted by the sense electrode contact 32, in particular gate sense electrode contact 32a. Due to the lateral distance between the control and the sense electrode contact 31, 32, the sense electrode contact 32 is connected to the control electrode contact 31, and gate voltage thus, via the sense resistance R_{sense_1}. When the drain potential rises quickly (fast transient), the voltage can rise at the sense electrode contact 32 due to the capacitive coupling with the capacitance C_{sense_1}, while the voltage at the control electrode contact 31 is tied to the gate voltage. In detail, the capacitance C_{Sense_1} is formed rather obliquely behind or in front of the drawing plane of figure 1, see figure 2 for comparison, and therefore shown in figure 1 only by dashed lines. This is the capacitance between gate and drain of the transistor device 10. The voltage rise at the sense electrode contact 32 can be used for an external evaluation or an internal circuitry, see below.

Alternatively or in addition to the gate electrode 26, the field electrode 27 can be used for sensing and considered as "first trench electrode" 30. Again, the lateral distance between the control and the sense electrode contacts 31, 32 gives an internal resistance R_{sense_2}. As indicated by way of example for the field electrode 27, the control electrode contact 31 is disposed in a first half 35.2 of the lateral extension 35 of the trench electrode 30, whereas the sense electrode contact 32 is disposed in a second half 35.1 thereof. The field electrode 27 is capacitively coupled to the drain region 12 via the capacitance C_{sense_2} so that a rise of the backside potential can be picked up capacitively and trigger a voltage rise at the sense electrode contact 32. The use of the gate electrode 26 or field electrode 27 for sensing can be alternatives (e. g. only one sense electrode contact provided) or they can be combined (wherein the field electrode 27 can be considered as "first trench electrode" and the gate electrode 26 as "second trench electrode", both used for sensing).

Figure 2 shows a cross-sectional view of the vertical device 10, the sectional plane perpendicular to the longitudinal direction of the trench 25. Generally, in this disclosure, the like reference numerals are used for the like elements or elements having the like function and reference is always made to the description of the other figures as well. The device 10 comprises a source region 11 at the first side 15.1 of the semiconductor body 15, below its body region 13 with a vertical channel region 13.1 are disposed. Laterally aside, a gate region 126 is arranged, comprising the gate electrode 26 and a gate dielectric 127 which capacitively couples the gate electrode 26 to the channel region 13.1.

In the same trench 25, a field electrode region 129 with the field electrode 27 and a field dielectric 128 are disposed. Via the field dielectric 128, the field electrode 27 is capacitively coupled to a drift region 14 of the device for a field shaping. The drift region 14 has the same doping type but a lower doping concentration than the drain region 12. In the example shown, the source region 11, drain region 12, and drift region 14 are n-doped and the body region 13 is p-doped.

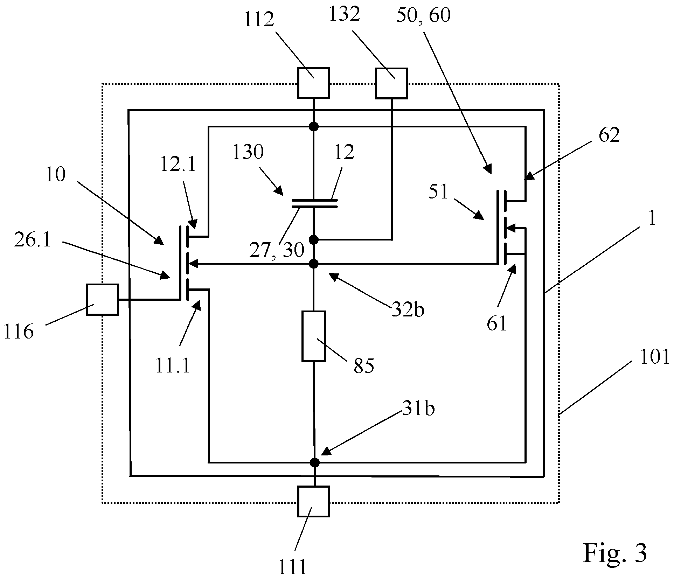

Figure 3 shows a circuit diagram and illustrates the connection of the die 1 in a package 101 (schematically shown). A source contact 11.1 of the device 10 can be contacted via a source pin 111 of the package 101, a drain contact 12.1 via a drain pin 112, and a gate contact 26.1 via a gate pin 116. In addition to the device 10, a controllable clamping device 50 is integrated in the die 1, namely a clamping field effect transistor 60 in the example shown. It has a source contact 61 and a drain contact 62 and is connected as a shunt device, namely in parallel to the vertical device 10. A control terminal 51, namely gate contact of the shunt FET, is connected to the sense electrode contact 32b (see the node in Fig. 3) and field electrode 27, thus. The field electrode 27 is an electrode of a capacitor 130, the other electrode is formed by the drain region 12.

As discussed above, a quick change of the drain potential can be sensed via a rise of the voltage at the sense electrode contact 32b, which switches the controllable clamping device 50 into the conducting state (see in detail the general description). The package 101 comprises additionally a sense pin 132 which is connected to the sense electrode contact of the first trench electrode 30. This can allow for an external evaluation and be combined with or be an alternative to the integrated clamping device 50. In the circuit diagram of figure 3, a resistor 85 is connected between the control terminal 51 and the source domain, the resistance R_{sense_2} of the resistor 85 being defined by the internal resistance of the first trench electrode 30, see above.

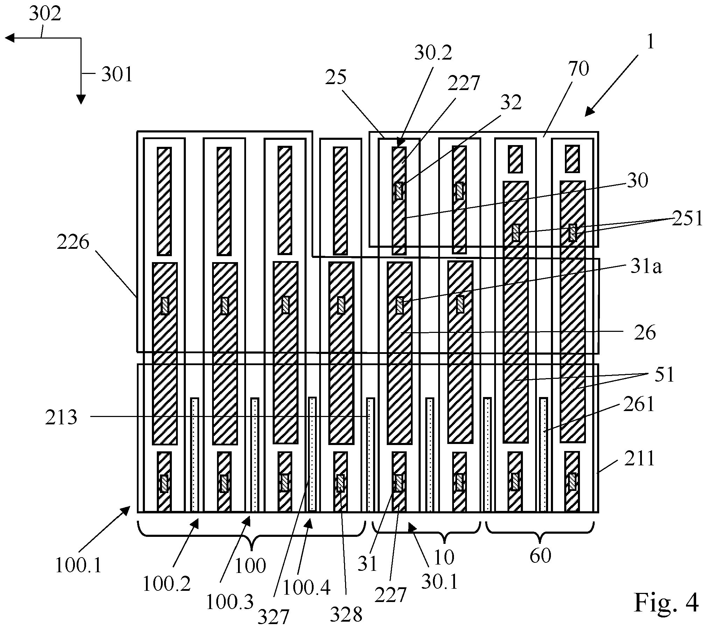

Figure 4 illustrates a possible layout in a vertical top view. The transistor device 10 with the first trench electrode 30 is arranged as a stripe-shaped cell, the trench 25 has an elongated extension. In a central portion of the trench 25, the gate electrode 26 is visible, which is contacted only by the gate electrode control contact 31a in this embodiment, namely not used for sensing. It is connected to a gate metal pad 226. Instead, the field electrode 27 disposed below the gate electrode 26 (and visible only at the edge of the trench in figure 4) is used as the first trench electrode 30, as detailed above. The field electrode material 227 is exposed upwards on both lateral sides of the gate electrode 26. There, the contacts 31, 32 are formed, namely the control electrode contact 31 at a first end 30.1 and the sense electrode contact 32 at a second end 30.2 of the first trench electrode 30. In the example shown, one further sense cell is connected in parallel, wherein both are referenced with the numeral 10 (but only one of them is referenced more in detail).

Via a body contact 213, the source and body region 11, 13 of the device 10 are connected to a source metal pad 211, see also figure 2 for illustration. Also, the field electrode of the device 10 is connected to the source metal pad 211, namely via the control electrode contact 31. This schematic image is not to scale, in particular the actual transistor section (see the arrow of the reference numeral 10) can be significantly longer in a first lateral direction 301 (longitudinal direction) than shown here, which applies in particular for the area enclosed by the source pad 211. A second lateral direction 302 perpendicular thereto can also be referred to as transverse direction.

Aside to the transistor device 10 (sense FET) in the second lateral direction 302, an additional transistor device 100 is disposed. It comprises a plurality of stripe-shaped device cells 100.1-100.4, each having a set up as illustrated in figure 2 for the device 10. In contrast thereto, the gate and field electrodes of the additional transistor device 100 are used only for channel creation and field shaping, not for sensing. The device cells 100.1-100.4 are connected in parallel to each other and to device 10 (sense FET), they have a common gate domain. Via respective contacts 327,328, its source and body region as well as its field plate are connected to the source metal pad 211.

The clamping field-effect transistor 60 (shunt FET) is arranged on the other side of the sense FET, namely on the right in figure 4. The control terminal 51 (gate electrode) of the clamping field-effect transistor 60 is connected via respective contacts 251 to a metal pad 70 which is also connected to the sense electrode contact 32. As discussed with reference to figure 3, the source domain of the clamping field-effect transistor 60 is connected to the source metal pad 211, namely via respective contacts 261. Moreover, the devices share the common drain backside.

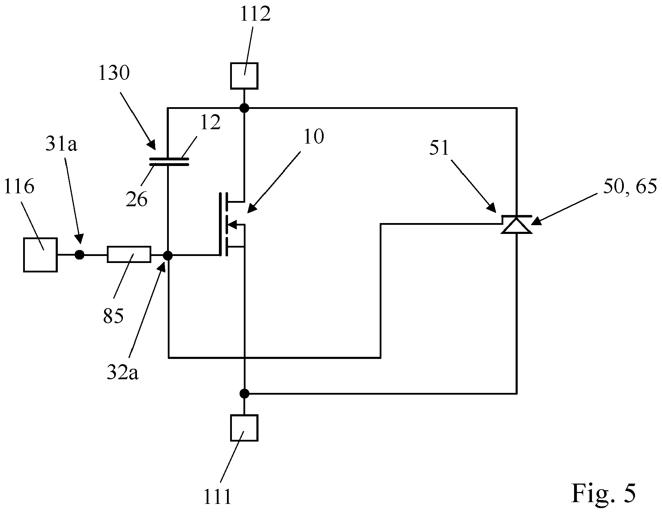

Figure 5 shows a circuit diagram for another embodiment, wherein the following description highlights mainly the differences. The gate electrode 26 is used for sensing and forms one electrode of the capacitor 130 (the gate electrode is used as first trench electrode, see the remarks on figure 1). The resistor 85 with the resistance R_{sense_1} is defined by the internal resistance of the gate electrode 26. Via the sense electrode contact 32a, the gate electrode 26 connects to the control terminal 51 of the controllable clamping device 50 which is a field electrode-controlled diode 65 in fig. 5.

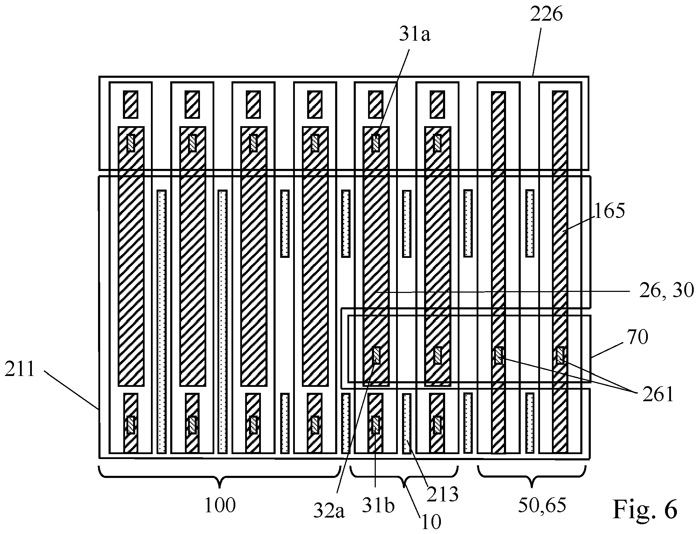

Figure 6 illustrates a possible layout and below mainly the differences to figure 4 are highlighted, the setup of figure 6 corresponds to the circuit diagram of figure 5. The gate electrode 26 is used for sensing and the field electrode-controlled diode 65 is used as controllable clamping device 50. The gate electrode 26 is the first trench electrode 30 and, in addition to its connection to the gate metal pad 226 via the control electrode contact 31a, it is connected to the metal pad 70 via the sense electrode contact 32a. Via the contacts 261, the metal pad 70 connects to the control terminal of controllable clamping device 50, namely to the field electrode 165 of the field electrode-controlled diode 65. The field electrode of the device 10, which is disposed below the gate electrode 26, connects to the source metal pad 211 via the field electrode control contact 31b, but in contrast to figure 4 is not contacted for sensing.

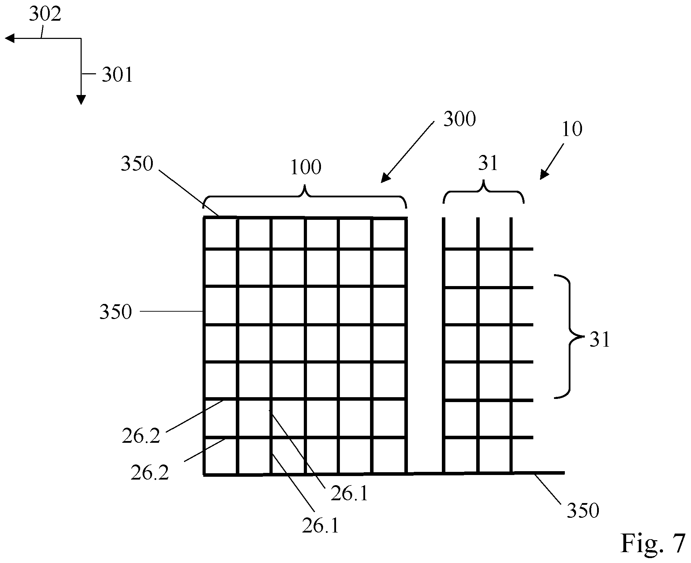

Though the above embodiments illustrate an implementation with stripe-shaped cells, the gate sense approach can also be realized in case of a grid-shaped gate structure 300, namely in case of polygonal or in particular quadratic cells illustrated schematically in figure 7. Gate electrodes 26.1 extending in the first lateral direction 301 and gate electrodes 26.2 extending in the second lateral direction 302 cross each other and form the grid. The additional transistor device 100 comprises a plurality of cells formed in this grid, which applies also for the transistor device 10 used for sensing (the cells are not referenced in detail). In between, some gate electrodes 26.2 extending in the second lateral direction are interrupted. This can for instance prevent the internal gate potential of the additional transistor device 100 from being affected by the gate sense potential (because of the capacitive loading of the shunt element). The gate runner 350 can for instance extend U-shaped around the additional transistor device 100 but leave one side of the sense FET unconnected, as shown. There, the sense electrode contacts 31 can be provided (different possible locations indicated in figure 7).

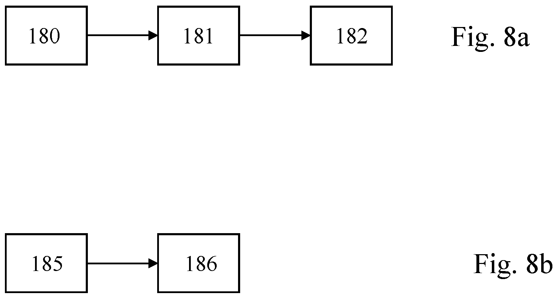

Figure 8a illustrates some steps of using a device or die disclosed here in a flow diagram. In addition to applying 180 an electrical potential to the first trench electrode, an electrical potential is sensed 181 via the sense electrode contact. Additionally, the sensed potential can be applied 182 to the control terminal of a controllable clamping device, see above.

Figure 8b illustrates some manufacturing steps. In addition to forming 185 the transistor device, the sense electrode contact is formed 186. Process wise, this can be integrated, the sense electrode contact made for instance during the forming 185 of the transistor device.

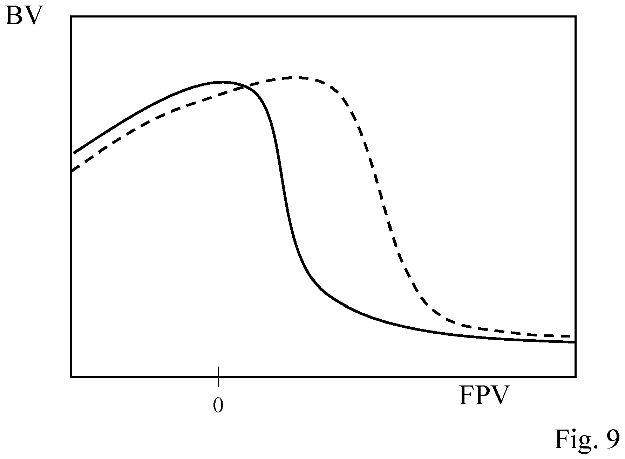

The diagram of figure 9 shows the dependence of the breakdown voltage (BV) on the y-axis from the field plate voltage (FPV) on the x-axis. Thereby, the transistor device (dashed line) and the field electrode-controlled diode (continuous line) are compared. The field electrode-controlled diode can have a higher breakdown voltage for FPV = 0V (static breakdown voltage) but a faster decay when the field plate voltage increases. Consequently, the respective shunt diode can take over the avalanche current when the field plate voltage rises during a dynamic avalanche.

## Claims

1. A semiconductor die (1) with a semiconductor body (15), the semiconductor die (1) comprising:
a transistor device (10) comprising:
a source region (11) at a first side (15.1) of the semiconductor body (15), a drain region (12) at a second side (15.2) of the semiconductor body (15), a trench (25) extending from the first side (15.1) into the semiconductor body (15) and having an elongated lateral extension,
a first trench electrode (30) for a channel creation or field shaping, having an elongated lateral extension (35) and disposed in the trench (25), and
a control electrode contact (31) contacting the first trench electrode (30) from the first side (15.1) of the semiconductor body (15) for applying an electrical potential, the control electrode contact (31) disposed at a first lateral position (41); and
a sense electrode contact (32) contacting the first trench electrode (30) from the first side (15.1) of the semiconductor body (15) for sensing a voltage from the first trench electrode (30), wherein the sense electrode contact (32) is disposed at a second lateral position (42) which is spaced apart from the first lateral position (41).

2. The semiconductor die (1) of claim 1, wherein the control electrode contact (31) is disposed in a first half (35.1) of the lateral extension (35) of the first trench electrode (30) and the sense electrode contact (32) is disposed in the second half (35.2) of the lateral extension (35), the control electrode contact (31) being in particular disposed at a first lateral end (30.1) of the first trench electrode (30) and the sense electrode contact (32) being in particular disposed at a laterally opposite second end (30.2) of the first trench electrode (30).

3. The semiconductor die (1) of claim 1 or 2, wherein no electrode contact contacting the first trench electrode (30) is disposed laterally between the control electrode contact (31) and the sense electrode contact (32).

4. The semiconductor die (1) of any one of the preceding claims, wherein the first trench electrode (30) is a gate electrode (26) disposed laterally aside a body region (13) of the transistor device (10) to create a channel in the body region (13).

5. The semiconductor die (1) of any one of claims 1 to 3, wherein the first trench electrode (30) is a field electrode (27) disposed laterally aside a drift region (14) of the transistor device (10) to shape a field in the drift region (14).

6. The semiconductor die (1) of claim 5, the transistor device (10) additionally comprising:
a gate electrode (26) disposed laterally aside a body region (13) of the transistor device (10) and capacitively coupled to the body region (13),
the gate electrode (26) having an elongated lateral extension and disposed in the trench (25) above the field electrode (27).

7. The semiconductor die (1) of any one of the preceding claims, additionally comprising:
a controllable clamping device (50) having a control terminal (51);
wherein the control terminal (51) of the controllable clamping device (50) is connected to the first trench electrode (30) via the sense electrode contact (32), the clamping device (50) connected in particular in parallel to the transistor device (10).

8. The semiconductor die (1) of claim 7, wherein the controllable clamping device (50) is one of:
a clamping field-effect transistor (60), a MOS-gated diode, and afield electrode-controlled diode (65).

9. The semiconductor die (1) of claim 7 or 8, additionally comprising:
a metal pad (70) disposed on the first side (15.1) of the semiconductor body (15);
the control terminal (51) of the controllable clamping device (50) connected to the sense electrode contact (32) of the first trench electrode (30) via the metal pad (70).

10. The semiconductor die (1) of any one of claims 7 to 9, wherein the control terminal (51) of the controllable clamping device (50) is connected to the source region (11) of the transistor device (10) via a resistor (85) with a resistance Rₛₑₙₛₑ, wherein the resistance Rₛₑₙₛₑ is defined by a resistance of the first trench electrode (30) between the control electrode contact (31) and the sense electrode contact (32), and/or
wherein the control terminal (51) of the controllable clamping device (50) is capacitively coupled to the drain region (12) of the transistor device (10) via a capacitor (130) with a capacitance Cₛₑₙₛₑ, wherein the capacitance Cₛₑₙₛₑ is defined by a capacitance between the first trench electrode (30) and the drain region (12)

11. The semiconductor die (1) of any one of claims 7 to 10, additionally comprising:
an additional transistor device (100) without a sense contact, connected in parallel to the transistor device (10);
wherein the transistor device (10), the additional transistor device (100) and the controllable clamping device (50) are disposed in separate trenches.

12. The semiconductor die (1) of any one of the preceding claims, additionally comprising:
an additional transistor device (100) without a sense contact, connected in parallel to the transistor device (10);
the additional transistor device (100) having a grid-shaped gate structure with gate electrodes (26.1) extending in a first lateral direction (301) and gate electrodes (26.2) extending in a second lateral direction (302), wherein the additional transistor device (100) and the transistor device (10) are arranged aside each other in the second lateral direction (302) and at least some of the gate electrodes (26.2) extending in the second lateral direction (302) are interrupted between the additional transistor device (100) and the transistor device (10).

13. A package (101) with the semiconductor die (1) of any one of the preceding claims,
the package (101) having a sense pin (132);
the sense pin (132) electrically connected to the sense electrode contact (32) of the semiconductor die (1).

14. A method of using the semiconductor die (1) of any one of the preceding claims, the method comprising the steps:
- applying (180) an electrical potential to the first trench electrode (30) via the control electrode contact (31);
- sensing (181) an electrical potential from the first trench electrode (30) via the sense electrode contact (32),
in particular additionally comprising the step:
- applying (182) the electrical potential sensed by the sense electrode contact (32) to a control terminal (51) of a controllable clamping device (50).

15. A method of manufacturing the semiconductor die (1) of any one of claims 1 to 12
or the package (101) of claim 13,
the method comprising the steps:
- forming (185) the transistor device (10);
- forming (186) the sense electrode contact (32).
